# FASCICULE DE BREVET EUROPEEN

(11) **EP 3 581 947 B1**
(45) Date de publication et mention de la délivrance du brevet: **29.07.2026**
(21) Numéro de dépôt: 19179113.6
(22) Date de dépôt: 07.06.2019
(51) Int. Cl.: H04B 3/46, H04M 1/72403, G01R 29/08

(54) **DETECTION DE CABLE D'UN RESEAU DE CABLES PAR UN EQUIPEMENT DE TELECOMMUNICATION**
DETEKTION EINES KABELS IN EINEM KABELNETZ FÜR EINE TELEKOMMUNIKATIONSAUSRÜSTUNG
DETECTION OF CABLE FROM A NETWORK OF CABLES BY TELECOMMUNICATIONS EQUIPMENT

(30) Priorité: 11.06.2018 FR 1855059
(43) Date de publication de la demande: 18.12.2019
(73) Titulaire: Orange, 92130 Issy-les-Moulineaux (FR)
(72) Inventeur: ESNAULT, Régis, 92326 CHÂTILLON CEDEX (FR); PAGANI, Pascal, 92326 CHÂTILLON CEDEX (FR)

(56) Documents cités:
- DE-A1- 102010 041 936
- US-A1- 2010 001 712
- US-A1- 2011 109 437
- US-A1- 2015 042 307
- US-A1- 2018 106 923

## Description

L'invention concerne la détection de câble d'un réseau de câbles, en particulier d'un réseau de câbles électriques, notamment non détectables à l'œil nu. Il peut s'agir, par exemple, de réseau de câbles électriques encastrés à l'intérieur des cloisons d'un bâtiment ou d'un sol (en intérieur ou en extérieur).

Lorsqu'un utilisateur souhaite connaître la disposition du réseau électrique (ou réseau de communication) de son domicile, par exemple avant de percer un mur pour éviter de sectionner un câble, ou afin de rajouter un boite de dérivation ou une nouvelle prise, il peut vérifier à quel disjoncteur est raccordée une prise donnée par un simple test en actionnant l'interrupteur de chaque disjoncteur puis suivre le câble lorsqu'il est visible.

Cependant, lorsque le réseau électrique est encastré à l'intérieur des cloisons, il est impossible de connaître la disposition des câbles par simple inspection visuelle. Il n'est donc pas possible d'avoir plus d'informations sur la structure du réseau électrique et en particulier, de retrouver l'ordre des prises électriques branchées en série sur une branche du réseau. Différents outils spécialisés de détection de câbles encastrés ont été élaborés pour pallier à ce problème comme des détecteurs de matériaux, et des traceurs de câbles.

Les détecteurs de matériaux tel que le détecteur scanner mural Detect 150 (marque déposée) de la marque Bosch fonctionne sur le principe du radar. L'outil de détection de matériaux émet un signal, notamment sous la forme d'une onde électromagnétique ou d'une onde acoustique tel que des ultrasons. Cette onde est réfléchie par les matériaux présents dans le mur, et en particulier par les câbles. Le signal réfléchi est capté par l'outil de détection de matériaux qui l'analyse : notamment qui calcule la durée de propagation de l'onde et/ou mesure la puissance du signal reçu. Ainsi l'outil de détection de matériaux fournit des informations de localisation des câbles notamment de distance à partir du calcul de durée de propagation et éventuellement des informations supplémentaires relatives aux câbles tels que le types de câbles, notamment de matériaux (métaux, plastiques, etc.) constituants le câble à partir de la puissance reçue.

Les traceurs de câbles, notamment l'instrument de traçage de conducteur décrit par la demande américaine US2018106923, proposent une détection de câbles avec une localisation plus précise que celle fournie par les détecteurs de matériaux. Ils exploitent la nature conductrice des câbles à détecter en émettant un signal électrique spécifique sur le câble tel que le câble ne se comporte plus comme un conducteur blindé mais rayonne une partie du signal sous la forme d'onde électromagnétique. Pour cela, les traceurs de câbles comportent deux équipements fonctionnant ensemble : un émetteur filaire et un récepteur de champs électromagnétique. L'émetteur du traceur de câbles est physiquement connecté à une extrémité du câble à détecter.

Par exemple, le traceur de câbles « Localisateur de Câble 2042 » (marque déposée) de la marque Fluke comporte un émetteur apte à être connecté au câble à l'aide de pinces, alors que l'émetteur du traceur de câbles « Wire Tracer PCE-191 CB » (marque déposée) de la marque PCE Instruments comporte une prise électrique mâle qui facilite son branchement sur les prises d'un réseau électrique d'un bâtiment. L'émetteur du traceur de câbles injecte le signal électrique caractéristique dans le câble à détecter, notamment un signal dont la fréquence est suffisamment haute pour que le signal soit rayonné par le câble. Le rayonnement se produit tout le long du câble et le niveau de champ électromagnétique rayonné est d'autant plus élevé près du câble. Le récepteur du traceur de câble mesure le niveau de champ électromagnétique perçu et affiche ce niveau, par exemple sous la forme d'un nombre ou d'un indicateur lumineux. En déplaçant, le récepteur du traceur de câbles le long d'un mur, l'utilisateur peut suivre les positions où le champ électromagnétique produit par le rayonnement du câble est le plus élevé et donc déterminer la position du câble à l'intérieur du mur.

Toutes ces solutions : détecteurs de matériaux, traceurs de câbles nécessitent des équipements électroniques complexes et onéreux qui sont dédiés uniquement à cet usage. Par conséquent, elles sont réservées aux professionnels du domaine. Cela implique donc des risques élevés d'incidents sur les réseaux de câbles d'un bâtiment car le bricolage est devenu une activité très appréciée par un grand nombre de personnes.

Un des buts de la présente invention est de remédier à des inconvénients de l'état de la technique.

Un objet de l'invention est un équipement de télécommunication comportant un récepteur de signaux électromagnétiques apte à recevoir des signaux de communication, caractérisé en ce que l'équipement de télécommunication comporte un détecteur d'un signal électrique prédéfini injecté dans un réseau de câbles en fonction de signaux électromagnétiques reçus par le récepteur.

Ainsi, le récepteur du traceur de câble n'est pas un équipement spécifique dédié uniquement à cet usage mais implémenté dans un équipement de télécommunication équipant largement les utilisateurs tels qu'un smartphone, une tablette, etc.

Avantageusement, l'équipement de télécommunication comporte :
- une interface de transmission filaire apte à être connecté à un réseau de câbles, et
- un générateur du signal électrique prédéfini apte à être injecté dans le réseau de câbles en utilisant l'interface de transmission filaire.

Ainsi, l'émetteur du traceur de câble n'est pas un équipement spécifique dédié uniquement à cet usage mais implémenté dans un équipement de télécommunication équipant largement les utilisateurs tels qu'un smartphone, une tablette, etc.

Avantageusement, l'équipement de télécommunication comporte un contrôleur d'émission de signaux électriques prédéfinis apte à déclencher une émission via une interface de transmission filaire d'un objet communicant du signal électrique prédéfini dans un réseau de câble auquel l'objet communicant est connecté au moyen de l'interface de transmission filaire.

Ainsi, la gestion de l'alimentation en particulier des batteries de l'équipement de télécommunication peut être optimisée puisque celui-ci a connaissance de l'instant d'émission du signal électrique prédéfini servant à la localisation de câble et peu donc activer ou désactiver le détecteur de signal électrique prédéfinis en conséquence.

Avantageusement, le détecteur de signal électrique prédéfini comporte un dispositif de mesure du niveau du signal reçu dans une bande de fréquence associé au récepteur.

Ainsi, la localisation de câble est réalisée de manière simple : c'est-à-dire ne mettant pas en œuvre des calculs complexes et par conséquent ne surchargeant par les moyens de calculs de l'équipement de télécommunication. L'avantage est que l'équipement de télécommunication ayant d'autres fonctions, ces autres fonctions ne sont pas ralenties ou gelées par l'utilisation de la localisation de câbles.

Avantageusement, l'équipement de télécommunication comporte un générateur d'une information de localisation en fonction du signal électrique prédéfini détecté par le détecteur, l'information de localisation étant apte à être reproduite par un dispositif de reproduction.

Ainsi, l'utilisateur accède de manière simplifiée à l'information de localisation.

Avantageusement, l'information de localisation est apte à commander un indicateur du dispositif de reproduction en fonction du niveau de champ électromagnétique du signal électrique prédéfini détecté par le détecteur.

Avantageusement, l'équipement de télécommunication comporte une caméra apte à capter une image unitaire lors de la mise en œuvre du détecteur du signal électrique prédéfini, l'image unitaire étant apte à être fournie au générateur d'information de localisation.

Ainsi, l'information de localisation fournie permet à l'utilisateur de repérer avec plus de précision la localisation réduisant encore les risques d'erreurs de localisation.

Avantageusement, l'équipement de télécommunication comporte un générateur d'image étendue en fonction d'images unitaires captées par la caméra lors de la mise en œuvre du détecteur du signal électrique prédéfini, l'image étendue étant apte à représenter un collage des images unitaires et à être fournie au générateur d'information de localisation.

Ainsi, l'utilisateur dispose d'une vue d'ensemble de la localisation d'un câble sur un pan de mur voire un mur entier, voire plusieurs murs (en 2D ou en 3D) au lieu d'une localisation point par point permettant une meilleure gestion des travaux à venir, voir l'élaboration de plan.

Avantageusement, le générateur d'image étendue utilise des données provenant d'au moins un accéléromètre de l'équipement de télécommunication.

Ainsi, la génération d'image étendue est facilitée.

Avantageusement, l'équipement de télécommunication comporte un dispositif de traitement d'image apte à surimposer sur une image une information en fonction du niveau de champ électromagnétique du signal électrique prédéfini détecté par le détecteur, l'image traitée étant apte à être fournie au dispositif de reproduction.

Un objet de l'invention est aussi un objet communicant d'un réseau de communication comportant un équipement de télécommunication selon l'invention, l'objet communicant comportant une interface de transmission filaire apte à être connecté à un réseau de câbles, caractérisé en ce que l'objet de communication comporte un générateur du signal électrique prédéfini apte à être injecté dans un réseau de câbles en utilisant l'interface de transmission filaire.

Ainsi, l'équipement de télécommunication dans lequel est implémenté le récepteur du traceur de câble ne nécessite pas d'être connecté par un câble très long au câble à détecter avec le risque de dégât sur le câble ou de déconnexion puisque c'est l'objet communicant qui est connecté à ce câble à détecter et dans lequel est implémenté l'émetteur du traceur de câble.

Un objet de l'invention est encore un procédé de localisation de réseau de câbles apte à être mis en oeuvre par un équipement de télécommunication, le procédé de localisation comportant une détection d'un signal électrique prédéfini en fonction de signaux électromagnétiques reçus par un récepteur de signaux électromagnétique de l'équipement de télécommunication apte à recevoir des signaux de communication suite à une injection du signal électrique dans un réseau de câbles.

Un objet de l'invention est un procédé de signalisation d'un réseau de câbles apte à être mis en oeuvre par un objet communicant d'un réseau de communication comportant un équipement de télécommunication apte à mettre en oeuvre le procédé de localisation selon l'invention, le procédé de signalisation d'un réseau de câble comportant une génération d'un signal électrique prédéfini apte à être injecté dans un réseau de câbles en utilisant l'interface de transmission filaire de l'objet communicant.

Avantageusement, le signal électrique prédéfini est émis sur une partie prédéterminée d'une bande de fréquence détectable par au moins un récepteur de signaux électromagnétiques d'un équipement de télécommunication apte à localiser un réseau de câbles.

Avantageusement, selon une implémentation de l'invention, les différentes étapes du procédé selon l'invention sont mises en œuvre par un logiciel ou programme d'ordinateur, ce logiciel comprenant des instructions logicielles destinées à être exécutées par un processeur de données d'un dispositif faisant partie d'un équipement de télécommunication ou d'un objet communicant et étant conçus pour commander l'exécution des différentes étapes de ce procédé.

L'invention vise donc aussi un programme comprenant des instructions de code de programme pour l'exécution des étapes du procédé de localisation et/ou du procédé de signalisation lorsque ledit programme est exécuté par un processeur.

Ce programme peut utiliser n'importe quel langage de programmation et être sous la forme de code source, code objet ou code intermédiaire entre code source et code objet tel que dans une forme partiellement compilée ou dans n'importe quelle autre forme souhaitable.

Les caractéristiques et avantages de l'invention apparaîtront plus clairement à la lecture de la description, faite à titre d'exemple, et des figures s'y rapportant qui représentent :
- Figures 1a et 1b, des schémas simplifiés de détecteurs de câble dédié selon l'art antérieur, respectivement de détecteurs de matériaux et de traceurs de câbles ;
- Figure 2, un schéma simplifié d'un équipement de télécommunication selon l'invention,
- Figure 3, un schéma simplifié d'une architecture de communication selon l'invention,
- Figure 4, un schéma simplifié du procédé de localisation de câbles selon l'invention,
- Figure 5, un schéma simplifié du procédé de signalisation selon l'invention.

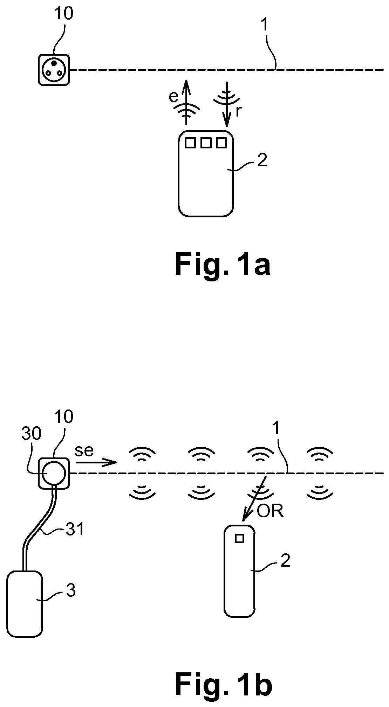

Les figures 1a et 1b illustrent des schémas simplifiés de détecteurs de câble dédié selon l'art antérieur.

En particulier, la figure 1a illustre un schéma simplifié d'un détecteur de matériaux selon l'art antérieur.

Le détecteur de matériau 2 émet des ondes e électromagnétiques ou acoustiques. Un câble 1 réfléchit l'onde émise e. L'onde réfléchie r est capté par l'outil de détection de matériaux qui l'analyse : notamment qui calcule la durée de propagation de l'onde et/ou mesure la puissance du signal reçu. Ainsi l'outil de détection de matériaux 2 fournie des informations de localisation des câbles notamment de distance à partir du calcul de durée de propagation et éventuellement des informations supplémentaires relatives aux câbles tels que le types de câbles, notamment de matériaux (métaux, plastiques, etc.) constituants le câble 1 à partir de la puissance reçue.

En particulier, la figure 1b illustre un schéma simplifié d'un traceur de câbles selon l'art antérieur.

Le traceur de câble comporte deux équipements : un émetteur 3 et un récepteur 2.

L'émetteur 3 est connecté au moyen d'un câble 31 à un câble 1 d'un réseau de câbles. Le câble 31 de l'émetteur 3 est terminé par une prise 30 permettant l'injection de signaux dans un câble 1 lorsque la prise 30 de l'émetteur 3 est enfichée dans une prise électrique 10 à l'extrémité d'un câble électrique 1. Notamment, la prise 30 de l'émetteur 3 est une prise électrique mâle qui facilite son branchement sur la prise 10 d'un câble électrique 1. L'émetteur 3 du traceur de câbles injecte un signal électrique se dans le câble 1.

Un rayonnement or se produit tout le long du câble 1. Le récepteur 2 du traceur de câble mesure le niveau de champ électromagnétique perçu et affiche ce niveau, par exemple sous la forme d'un nombre ou d'un indicateur lumineux. En déplaçant, le récepteur 2 du traceur de câbles le long d'un mur, l'utilisateur peut suivre les positions où le champ électromagnétique produit par le rayonnement du câble 1 est le plus élevé et donc déterminer la position du câble à l'intérieur du mur.

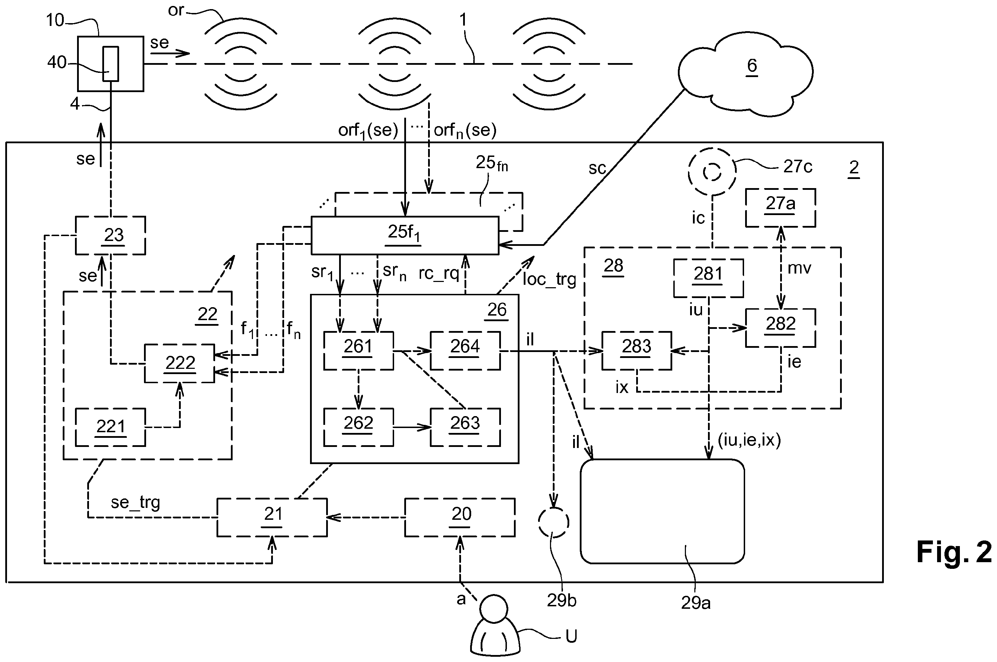

La figure 2 est un schéma simplifié d'un équipement de télécommunication selon l'invention.

L'équipement de télécommunication 2 comporte un récepteur de signaux électromagnétiques 25_{f1}... 25_{fn} apte à recevoir des signaux de communication sc et un détecteur 26 d'un signal électrique prédéfini se injecté dans un réseau de câbles, aussi nommés réseau de conducteurs, en fonction de signaux électromagnétiques or reçus par le récepteur 25_{f1}... 25_{fn}.

En particulier, l'équipement de télécommunication 2 comporte :
- une interface de transmission filaire 23, notamment un port de transfert de données, apte à être connecté à un réseau de câbles 1, et
- un générateur 22 du signal électrique prédéfini se apte à être injecté dans le réseau de câbles 1 en utilisant l'interface de transmission filaire 23.

L'interface de transmission filaire 23 est, par exemple, une interface de charge électrique.

En particulier, l'interface de transmission filaire 23 est reliée au moyen d'un câble 4 au câble 1 à détecter. Le câble 4 est connecté au câble 1, par exemple, au moyen d'une prise 40 enfiché dans une prise 10 placée sur le câble 1. Dans un mode de réalisation particulier, l'interface de transmission filaire 23 est un port unique utilisé pour deux fonctions : l'alimentation de la batterie et le transfert de données, tel qu'un port micro-USB de type B.

En particulier, l'équipement de télécommunication 2 comporte un contrôleur 21 d'émission de signaux électriques prédéfinis apte à déclencher *se_trg* une émission via une interface de transmission filaire 23,33 d'un objet communicant 2, 3 du signal électrique prédéfini se dans un réseau de câble 1 auquel l'objet communicant 2,3 est connecté au moyen de l'interface de transmission filaire 23,33. L'objet communicant 2,3 est notamment l'équipement de télécommunication 2 tel qu'illustré par la figure 2 ou un objet communicant 3 distinct de l'équipement de télécommunication 2.

En particulier, l'équipement de télécommunication 2 comporte une interface homme machine 20 permettant à l'utilisateur U de déclencher ou d'activer le détecteur 26 et/ou le générateur de signal électrique 22. Notamment, lorsque l'utilisateur U active le détecteur 26, le contrôleur 21 déclenche *se_trg* le générateur 22 de signal électrique. Inversement, lorsque l'utilisateur U active le générateur 22 de signal électrique, le contrôleur 21 déclenche *loc_trg* le détecteur 26.

En particulier, le générateur de signal électrique 22 comporte un générateur de forme d'onde 221 apte à être facilement détecté. Les formes d'onde sont, par exemple, des formes d'ondes fréquentielle et/ou temporelle. Par exemple, la forme d'onde est obtenue en répétant un motif fréquentiel et/ou temporel particulier.

En outre, le générateur de signal électrique 22 comporte, en particulier, un modulateur de fréquence 222 apte à permettre au signal électrique généré se d'occuper une bande de fréquence couvrant tout ou partie de la bande de fréquence détectable f₁ ...fₙ par les récepteurs 25_{f1}...25_{fn} de l'équipement de télécommunication 2.

Le détecteur 26 est notamment connecté à un récepteur 25_{f1}...25_{fn} apte à détecter des champs électromagnétiques. En particulier, le détecteur de signal électrique prédéfini 26 comporte un dispositif de mesure 261 du niveau du signal reçu sr₁...srₙ dans une bande de fréquence associé au récepteur 25_{f1}... 25_{fn}. Notamment, le détecteur 26 est un analyseur apte à localiser en fonction des champs électromagnétiques détectés le câble 1 via lequel le signal se a été émis.

En particulier, le détecteur 26 comporte un discriminateur 263 du signal électrique prédéfini se dans le signal reçu sr₁...srₙ fourni par le récepteur 25_{f1}... 25_{fn}. Notamment, le détecteur 26 comporte un échantillonneur 262 du signal reçu sr₁...srₙ fourni par le récepteur 25_{f1}... 25_{fn} apte à fournir le signal reçu échantillonné Sr au discriminateur 263.

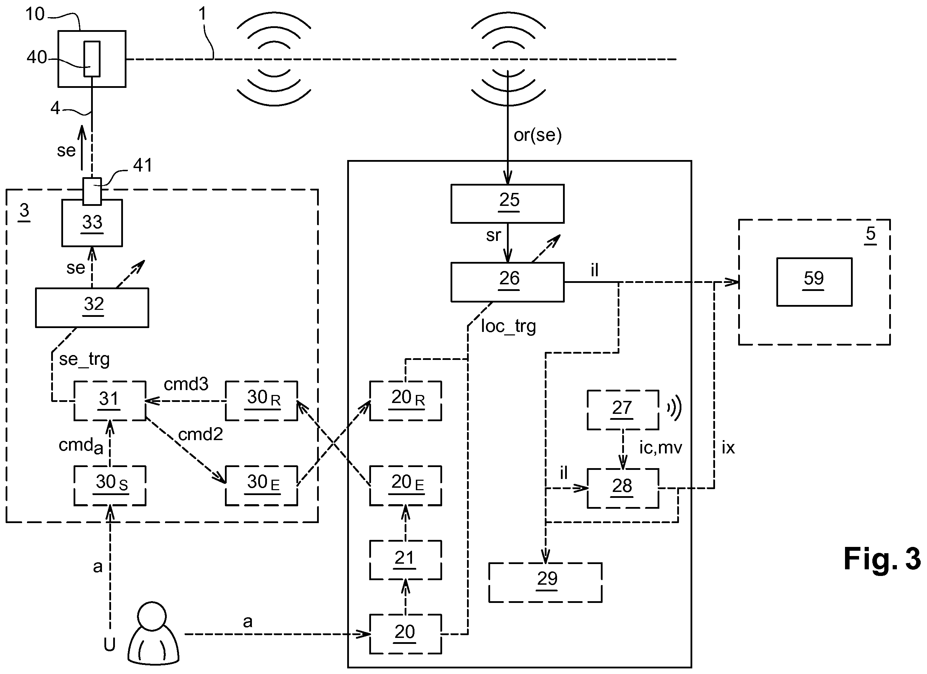

En particulier, l'équipement de télécommunication 2 comporte un générateur d'une information de localisation 264, 283 en fonction du signal électrique prédéfini détecté par le détecteur 26, l'information de localisation *il* étant apte à être reproduite par un dispositif de reproduction 29a, 29b. Le dispositif de reproduction 29a, 29b est implémenté dans l'équipement de télécommunication 2 tel qu'illustré par la figure 2 ou dans un équipement de reproduction communicant 5 tel qu'illustré par la figure 3. Eventuellement le générateur d'information de localisation 264 est implémenté dans le détecteur 26 tel qu'illustré par la figure 2.

En particulier, l'information de localisation *il* est apte à commander un indicateur du dispositif de reproduction 29a, 29b en fonction du niveau de champ électromagnétique du signal électrique prédéfini se détecté par le détecteur 26.

En particulier, l'équipement de télécommunication 2 comporte une caméra 27c apte à capter une image unitaire *iu* lors de la mise en œuvre du détecteur 26 du signal électrique prédéfini, l'image unitaire *iu* étant apte à être fournie au générateur d'information de localisation 283.

En particulier, l'équipement de télécommunication 2 comporte un générateur d'image étendue 282 en fonction d'images unitaires *iu* captées par la caméra 27c lors de la mise en oeuvre du détecteur 26 du signal électrique prédéfini, l'image étendue *ie* étant apte à représenter un collage des images unitaires *iu* et à être fournie au générateur d'information de localisation 283.

En particulier, le générateur d'image étendue 282 utilise des données provenant d'au moins un accéléromètre 27a de l'équipement de télécommunication 2.

En particulier, l'équipement de télécommunication 2 comporte un dispositif de traitement d'image 283 apte à surimposer sur une image *iu, ie* une information *il* en fonction du niveau de champ électromagnétique du signal électrique prédéfini se détecté par le détecteur 26, l'image traitée ix étant apte à être fournie au dispositif de reproduction 29a.

En particulier, l'équipement de télécommunication 2 est un terminal de communication, tel qu'un smartphone, une tablette...

L'avantage est que les utilisateurs disposent généralement déjà de tels équipements de télécommunication 2 et du câble 4 qui sert à brancher le smartphone 2 pour l'alimentation. Les smartphones sont munis de moyens de réception de signaux électromagnétiques mis en œuvre pour la réception de signaux de communication sans fil (notamment de signaux de communication mobile via un réseau de téléphonie mobile 6 par exemple). Ces récepteurs sont composés d'une antenne de réception 25 et d'un circuit de réception du signal, servant dans l'invention de détecteur 26. Les circuits de réception 26 comprennent des moyens de mesure du niveau du signal reçu 261, d'échantillonneurs 262 et de moyen de stockage du signal reçu (non illustré), par exemple mémoire tampon.

En général, une ou plusieurs chaînes de réception (antenne + circuit) sont disponibles pour un équipement de télécommunication 2 tel qu'un smartphone, en fonction des standards de communication implémentés. Par exemple, un smartphone comporte aujourd'hui des récepteurs 25 :
- pour des signaux GSM dans les bandes de fréquences autour de 900MHz ou 1800MHz,
- pour des signaux 3G dans les bandes de fréquences autour de 900MHz et 2100MHz,
- pour des signaux 4G dans les bandes de fréquences autour de 800MHz, 1800Mz et 2600MHz,
- pour des signaux Bluetooth (marque déposée) dans les bandes de fréquences autour de 2400MHz,
- pour des signaux Wifi (marque déposée) dans les bandes de fréquences autour de 2400MHz et 5000MHz,
- etc.

Un exemple d'équipement de télécommunication selon l'invention est un smartphone 2 qui utilise au moins une chaine de réception 25, 26 pour capter le signal électrique prédéfini injecté dans le câble 1. Le signal électrique se est émis dans l'une des bandes de fréquences utilisées par l'un des récepteurs 25 du smartphone 2. Ceci est notamment réalisé à l'aide d'un port de transmission utilisant la norme USB 3.0 capable d'émettre des signaux avec une puissance significative dans une bande de fréquence de 0 à 3000MHz.

Le smartphone 2 est muni d'un écran 29a permettant d'afficher des informations, notamment le niveau de champ électromagnétique mesuré par le détecteur 26 et/ou des informations de localisation fournies par le générateur d'information de localisation 264, 283. Une manière de localiser le câble 1 est d'affiché sur l'écran 29a ou un indicateur, tel qu'une diode électroluminescente ou Led, ou une série de diodes, etc., une information indiquant le niveau de champ électromagnétique mesuré sous la forme d'un code couleur, d'un niveau de barre ou nombre, etc. En déplaçant le smartphone 2 à proximité d'un mur dans lequel est encastré le câble 1, l'utilisateur U pourra observer les endroits où le rayonnement électromagnétique or est le plus puissant et donc localiser l'emplacement du câble électrique 1.

Afin d'améliorer à la fois la précision et l'attractivité de l'interface homme-machine, l'invention concerne également une procédé avancée de visualisation de la localisation du câble notamment mis en œuvre par le procédé de localisation selon l'invention, utilisant les moyens matériels déjà présents dans le smartphone 2. En utilisant la caméra 27c du smartphone2, une image du mur peut être représentée sur l'écran 29a du smartphone 2. Lorsque le détecteur 26 démarre le dispositif de mesure 261, un premier niveau de champ rayonné *lv₁* est mesuré et associé à cette image unitaire *iu₁* par le générateur d'image unitaire 281. La mesure est poursuivie en déplaçant le smartphone 2. Alors, de nouvelles images unitaires du mur *iuᵢ* et le niveau de champ rayonné *lvᵢ* associé à chaque image unitaire sont obtenus de manière continue et successive. Le générateur d'image étendue 282 est alors apte à construire progressivement une image étendue du mur *ie*, notamment par superposition et collage des images unitaires obtenues {*iuᵢ*}ᵢ*.* Le générateur d'image étendue 282 met notamment en œuvre un procédé de génération d'image étendue similaire au procédé de génération de photo panoramique à la volée mis en oeuvre par les appareils photos numériques (et les smartphones).

Le générateur d'information de localisation 283 est notamment apte à associer à chaque pixel de l'image étendue *ie* un niveau de puissance rayonnée calculé qui est fonction des niveaux mesurés lvᵢ associés aux images unitaires iuᵢ qui incluent ce pixel. Par exemple, le niveau de puissance rayonnée calculé associé à un pixel de l'image étendue est la moyenne des niveaux mesurés associés aux images unitaires qui incluent ce pixel.

Ainsi, le générateur d'information de localisation 283 peut fournir à l'écran 29a:
- soit l'image unitaire en cours d'observation sur laquelle a été superposé un niveau de rayonnement (sous la forme d'une superposition semi-transparente en code couleur par exemple), correspondant au niveau de puissance rayonnée calculé pour la partie de l'image étendue en cours de visualisation.
- soit l'image étendue du mur sur laquelle a été superposé, pour chaque pixel un niveau de rayonnement (sous la forme d'une superposition semi-transparente en code couleur par exemple), correspondant au niveau de puissance rayonnée calculé pour ce pixel de l'image étendue.

Par cette technique, une image du mur augmentée *ix* d'une information de rayonnement avec une résolution fine est obtenue. En pratique, l'utilisateur U voit, sur l'écran 29a, le mur et la localisation du niveau de rayonnement de manière superposée. Ce type de visualisation est particulièrement utilisé dans le domaine de la réalité augmentée.

Notons que pour la génération de l'image étendue *ie*, le smartphone 2 peut se baser uniquement sur les images captées par la caméra 29a et réaliser la superposition et le collage uniquement par traitement d'image. Cette fonctionnalité peut cependant être améliorée en associant des informations sur le déplacement du smartphone collectées par un autre capteur 27a, comme son accéléromètre par exemple.

La figure 3 illustre un schéma simplifié d'une architecture de communication selon l'invention.

L'architecture de communication comporte un équipement de télécommunication notamment tel que celui décrit par la figure 2, un câble de connexion 4 d'un dispositif de communication tel que l'équipement de télécommunication 2 ou un objet communicant 3 à un câble 1 d'un réseau de câbles. En outre, l'architecture de communication comporte éventuellement un objet communicant 3 et/ou un dispositif de reproduction communicant 5.

L'objet communicant 3 comporte une interface de transmission filaire 33 apte à être connecté à un réseau de câbles 1, et un générateur 32 du signal électrique prédéfini se apte à être injecté dans un réseau de câbles 1 en utilisant l'interface de transmission filaire 33.

En particulier, l'interface de transmission filaire 33 est reliée au moyen d'un câble 4 au câble 1 à détecter. Le câble 4 est connecté au câble 1, par exemple, au moyen d'une prise 40 enfiché dans une prise 10 placée sur le câble 1. Dans un mode de réalisation particulier, l'interface de transmission filaire 33 est un port unique utilisé pour deux fonctions : l'alimentation de la batterie et le transfert de données, tel qu'un port micro-USB de type B.

En particulier, l'objet communicant 3 comporte un contrôleur 31 de localisation apte à déclencher *loc_trg* une localisation de câble en utilisant au moins un récepteur de signaux électromagnétiques 25 d'un équipement de télécommunication 2 apte à recevoir un signal électromagnétique produit par le rayonnement d'un signal électrique prédéfini se dans un réseau de câble 1 auquel l'objet communicant 2,3 est connecté au moyen de l'interface de transmission filaire 33. L'objet communicant 3 est notamment l'équipement de télécommunication 2 tel qu'illustré par la figure 2 ou un objet communicant 3 distinct de l'équipement de télécommunication 2 comme illustré par la figure 3.

En particulier, l'objet de communication 3 comporte un émetteur 30_{E} et/ou un récepteur 30_{R} permettant à l'objet communicant d'échanger avec l'équipement de télécommunication 2. Ainsi, l'émetteur 30_{E} est apte à émettre la commande de déclenchement *loc_trg* générée par le contrôleur 31 à destination de l'équipement de télécommunication 2.

En particulier, l'objet communicant 3 comporte une interface homme machine 30 permettant à l'utilisateur U de déclencher ou d'activer le générateur de signal électrique 32. Notamment, lorsque l'utilisateur U active le générateur 32 de signal électrique, le contrôleur 31 déclenche *loc_trg* le détecteur 26 de l'équipement de télécommunication 2.

De manière alternative, le générateur de signal électrique 32 est commandé *se_trg* par l'équipement de télécommunication 2 : notamment son déclenchement ou son activation est effectuée suite à la réception par le récepteur 30R d'une commande *se_trg* de déclenchement du générateur de signal électrique 32 émise par l'équipement de télécommunication 2.

En particulier, le générateur de signal électrique 32 comporte un générateur de forme d'onde 321 apte à être facilement détecté (non illustré). Les formes d'onde sont, par exemple, des formes d'ondes fréquentielle et/ou temporelle. Par exemple, la forme d'onde est obtenue en répétant un motif fréquentiel et/ou temporel particulier.

En outre, le générateur de signal électrique 32 comporte, en particulier, un modulateur de fréquence 322 (non illustré) apte à permettre au signal électrique généré se d'occuper une bande de fréquence couvrant tout ou partie de la bande de fréquence détectable f₁ ...fₙ par les récepteurs 25_{f1}...25_{fn} de l'équipement de télécommunication 2.

L'équipement de télécommunication 2 comporte un récepteur 25 apte à recevoir des signaux électromagnétiques dont ceux or(se) provenant du rayonnement par le câble 1 du signal électrique se généré puis injecté par l'objet communicant dans le câble 1 via le câble de connexion 4 au réseau de câble, et un détecteur 26 apte à localiser le câble 1 à partir des signaux électromagnétiques reçus *sr.*

En particulier, l'équipement de télécommunication 2 comporte un contrôleur 21 d'émission de signaux électriques prédéfinis apte à déclencher *se_trg* une émission via une interface de transmission filaire 33 d'un objet communicant 3 du signal électrique prédéfini se dans un réseau de câble 1 auquel l'objet communicant 3 est connecté au moyen de l'interface de transmission filaire 33.

En particulier, l'équipement de télécommunication 2 comporte un émetteur 20_{E} et/ou un récepteur 20_{R} permettant à l'équipement de télécommunication 2 d'échanger avec l'objet communicant 3. Ainsi, l'émetteur 20_{E} est apte à émettre la commande de déclenchement *se_trg* générée par le contrôleur 21 à destination de l'objet communicant 3.

En particulier, l'équipement de télécommunication 2 comporte une interface homme machine 20 permettant à l'utilisateur U de déclencher ou d'activer le détecteur 26. Notamment, lorsque l'utilisateur U active le détecteur 26, le contrôleur 21 déclenche *se_trg* le générateur 22 de signal électrique.

De manière alternative, le détecteur 26 est commandé *loc_trg* par l'objet communicant 3: notamment son déclenchement ou son activation est effectuée suite à la réception par le récepteur 20R d'une commande *loc_trg* de déclenchement du détecteur 26 émise par l'objet communicant 3.

Eventuellement, l'équipement de télécommunication 2 comporte au moins un parmi les dispositifs suivants décrits plus précisément à la lecture de la figure 2 :
- un capteur 27, tel qu'une caméra, un accéléromètre, etc. ;
- un générateur d'image enrichie par la localisation 28 ;
- un reproducteur d'information de localisation 29, tel qu'un indicateur, un écran, etc.

De manière alternative, le reproducteur d'information de localisation 29 n'est pas implémenté par l'équipement de localisation mais dans un dispositif de reproduction 5 distinct de l'équipement de télécommunication 2.

Plusieurs cas d'usage sont envisageables :
Une tablette ou un smartphone correspondant à l'équipement de télécommunication 2 de la figure 2 est connecté au moyen d'un câble de recharge notamment USB au câble à détecter via une prise du réseau de câble (câble électrique mais aussi câble téléphonique, etc.). Il est soit déplacé le long du ou des murs dans lesquels est encastré le câble soit placé à une position de détection relative à ce ou ces murs de telle sorte à mesurer les signaux électromagnétiques sur la totalité du ou des murs.

Afin d'éviter l'utilisation de câble de connexion long, d'autres cas d'usage sont envisagé.

Un objet connecté tel qu'une montre, un bouton connecté, etc. constituant l'objet communication 3 et une tablette ou smartphone constituant l'équipement de télécommunication 2 tel qu'illustré par la figure 3. L'objet connecté à un réseau de télécommunication (local et/ou distant) est connecté au moyen d'un câble de recharge notamment USB au câble à détecter via une prise du réseau de câble (câble électrique mais aussi câble téléphonique, etc.). Le smartphone est soit déplacé le long du ou des murs dans lesquels sont encastrés le câble soit placé à une position de détection relative à ce ou ces murs de telle sorte à mesurer les signaux électromagnétiques sur la totalité du ou des murs.

Inversement, la tablette ou le smartphone est connecté au moyen d'un câble de recharge notamment USB au câble à détecter via une prise du réseau de câble (câble électrique mais aussi câble téléphonique, etc.). Et, c'est l'objet connecté qui est soit déplacé le long du ou des murs dans lesquels sont encastrés le câble soit placé à une position de détection relative à ce ou ces murs de telle sorte à mesurer les signaux électromagnétiques sur la totalité du ou des murs. Dans cette option, il peut être envisagé que le dispositif de reproduction soit distinct de l'objet connecté et du smartphone, par exemple une télévision connectée ou que le dispositif de reproduction utilisé ne soit pas celui de l'objet connecté détectant le rayonnement mais de la tablette ou du smartphone injectant le signal électrique.

L'avantage d'utiliser des équipements de télécommunication et/ou objet communicant pour mettre en œuvre la détection de câble est que les informations de localisation générées peuvent être stockées dans ces équipements ou dans un équipement du réseau de communication et/ou être utilisées par d'autres dispositifs tels que les dispositifs de créations utilisés par les architectes et/ou maître d'ouvrage sur site ou à distance puisque ces équipements de télécommunication peuvent transmettre les informations de localisation générées sous forme de signal et/ou de fichier de données. En particulier, l'équipement de télécommunication de l'invention peut aussi comporter un modélisateur 3D apte à générer des plans 3D d'un bâtiment incorporant la localisation des câbles détectés.

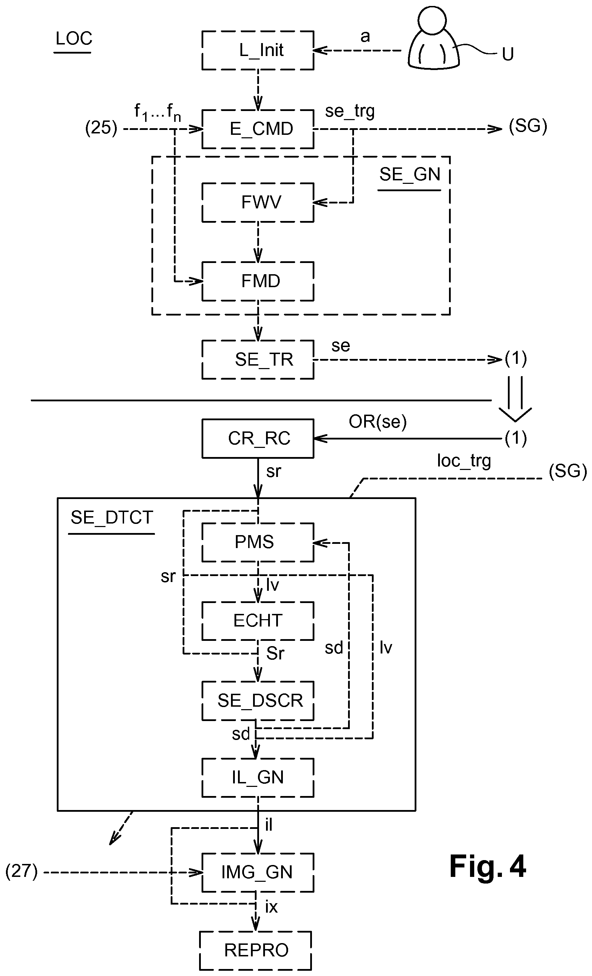

La figure 4 illustre un schéma simplifié du procédé de localisation de câbles selon l'invention.

Le procédé de localisation LOC de réseau de câbles apte à être mis en oeuvre par un équipement de télécommunication 2 comporte, suite à une injection d'un signal électrique se dans un réseau de câbles 1, une détection du signal électrique prédéfini SE_DTCT en fonction de signaux électromagnétiques reçus *or(se)* par un récepteur de signaux électromagnétique 25 de l'équipement de télécommunication 2 apte à recevoir des signaux de communication sc.

En particulier, le procédé de localisation LOC comporte, suite à une injection d'un signal électrique se dans un réseau de câbles 1, une réception OR_RC de signaux électromagnétiques or(se) par un récepteur de signaux électromagnétique 25 de l'équipement de télécommunication 2.

En particulier, le procédé de localisation LOC comporte une génération d'image enrichie IMG_GN utilisant les données de localisation obtenues lors de la détection SE_DTCT.

Notamment, les données de localisation LOC sont des niveaux de champs électromagnétiques *lv.* En particulier, le procédé de localisation LOC comporte une mesure de la puissance PMS du champ électromagnétique produit par le rayonnement or(se) par le câble 1 du signal électrique se injecté. Une manière simple de mesurer le niveau de champ électromagnétique consiste à capter tout le signal reçu dans la bande de fréquence reçue par le récepteur de l'équipement de télécommunication 2 et de réaliser une mesure de niveau à l'aide des dispositifs disponibles dans la chaîne de réception de l'équipement de télécommunication 2.

Notamment, les données de localisation LOC sont un signal discriminé sd. En particulier, le procédé de localisation comporte une discrimination du signal électrique prédéfini SE_DSCR dans le signal reçu *sr* lors de la réception OR_RC. Eventuellement, la discrimination SE_DSCR est fonction de la puissance mesurée *lv.* La discrimination SE_DCSR met notamment en œuvre une méthode de corrélation entre le signal reçu *sr* et le signal prédéfini injecté se. La discrimination permet une mesure plus précise du niveau de signal reçu correspondant au signal prédéfini uniquement.

En particulier, le procédé de localisation LOC comporte un échantillonnage ECHT du signal reçu *sr.* Alors, la discrimination SE_DSCR est effectué non pas directement sur le signal reçu sr mais le signal échantillonné Sr.

En particulier, la mesure de puissance PMS est effectuée à partir du signal discriminé *sd.*

Notamment, les données de localisation LOC sont une information de localisation *il.* En particulier, le procédé de localisation LOC comporte un générateur d'information de localisation IL_GN en fonction de la puissance mesurée *lv* et/ou du signal discriminé sd, etc.

En particulier, la détection SE_DTCT comporte au moins une des étapes suivantes :
- mesure de puissance PMS,
- échantillonnage ECHT,
- discrimination SE_DSCR,
- génération d'information de localisation IL_GN.

Un mode de réalisation du procédé de localisation LOC est un programme comprenant des instructions de code de programme pour l'exécution des étapes du procédé de localisation lorsque ledit programme est exécuté par un processeur, notamment de l'équipement de télécommunication.

Lorsque l'équipement de télécommunication 2 est aussi utilisé pour injecter le signal électrique prédéfini se dans le câble 1, le procédé de localisation LOC mis en œuvre par l'équipement de télécommunication 2 comporte en outre l'émission du signal électrique SE_TR sur le câble 1.

Dans ce cas d'usage, le procédé de localisation LOC comporte, en particulier, une génération d'un signal électrique prédéfini SE_GN fournie à l'émission SE_TR.

Notamment, la génération du signal électrique SE_GN comporte une génération de forme d'onde FWV spécifique utilisée pour générer le signal électrique se. La forme d'onde du signal électrique : forme d'onde fréquentielle et/ou temporelle est notamment définie de tel sorte que le taux de détection soit augmenté. Par exemple, la forme d'onde est générée en répétant un motif fréquentiel et/ou temporel particulier.

En particulier, la génération du signal électrique SE_GN comporte une modulation de fréquence FMD telle que la bande de fréquence occupée par le signal électrique se couvre tout ou partie de la bande de fréquence f1...fn du ou des récepteurs 25 de l'équipement de télécommunication 2.

En particulier, l'utilisateur demande a l'activation du procédé de localisation LOC lors d'une étape d'initialisation L_Init. Cette étape déclenche la détection SE_DTCT et/ou la génération du signal électrique SE_GN.

Lorsque le procédé de localisation LOC ne comporte pas la génération du signal électrique SE_GN, le procédé de localisation comporte, en particulier, un contrôle de l'émission du signal électrique E_CMD transmettant une commande de déclenchement se_trg à un procédé de signalisation SG.

De manière alternative, la détection SE_DTCT est déclenchée *loc_trg* par procédé de signalisation SG mettant en oeuvre l'injection dans le câble 1 du signal électrique se.

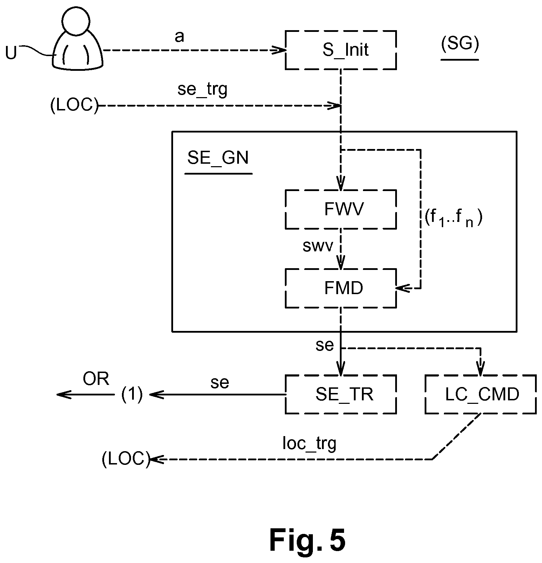

La figure 5 illustre un schéma simplifié du procédé de signalisation selon l'invention

Le procédé de signalisation SG d'un réseau de câbles apte à être mis en œuvre par un objet communicant 3 comporte une génération d'un signal électrique prédéfini SE_GN apte à être injecté dans un réseau de câbles 1 en utilisant l'interface de transmission filaire de l'objet communicant 3.

En particulier, le signal électrique prédéfini se présente une forme d'onde apte à être détectée.

En particulier, le signal électrique prédéfini se est émis sur une partie prédéterminée d'une bande de fréquence détectable par au moins un récepteur de signaux électromagnétiques 25 d'un équipement de télécommunication 2 apte à localiser un réseau de câbles 1.

Dans ce cas d'usage, le procédé de signalisation SG comporte, en particulier, une transmission ou injection SE_TR du signal électrique prédéfini générée se dans un câble 1 d'un réseau de câbles.

Notamment, la génération du signal électrique SE_GN comporte une génération de forme d'onde FWV spécifique utilisée pour générer le signal électrique se. La forme d'onde du signal électrique : forme d'onde fréquentielle et/ou temporelle est notamment définie de telle sorte que le taux de détection soit augmenté. Par exemple, la forme d'onde est générée en répétant un motif fréquentiel et/ou temporel particulier.

En particulier, la génération du signal électrique SE_GN comporte une modulation de fréquence FMD telle que la bande de fréquence occupée par le signal électrique se couvre tout ou partie de la bande de fréquence f1...fn du ou des récepteurs 25 de l'équipement de télécommunication 2.

En particulier, l'utilisateur demande a l'activation du procédé de signalisation SG lors d'une étape d'initialisation S_Init. Cette étape déclenche la génération SE_GN.

En particulier, le procédé de signalisation SG comporte, en particulier, un contrôle de la localisation LC_CMD transmettant une commande de déclenchement loc_trg à un procédé de localisation LOC.

De manière alternative, la génération de signal électrique SE_GN est déclenchée *se_trg* par un procédé de localisation LOC recevant le rayonnement *or* du signal électrique se injecté dans le câble 1.

Un mode de réalisation du procédé de signalisation est un programme comprenant des instructions de code de programme pour l'exécution des étapes du procédé de signalisation lorsque ledit programme est exécuté par un processeur.

Ainsi, l'invention peut être déployée sur des dispositifs de communications sous la forme d'applications logicielles.

L'invention vise aussi un support. Le support d'informations peut être n'importe quelle entité ou dispositif capable de stocker le programme. Par exemple, le support peut comporter un moyen de stockage, tel qu'une ROM, par exemple un CD ROM ou une ROM de circuit microélectronique ou encore un moyen d'enregistrement magnétique, par exemple une disquette ou un disque dur.

D'autre part, le support d'informations peut être un support transmissible tel qu'un signal électrique ou optique qui peut être acheminé via un câble électrique ou optique, par radio ou par d'autres moyens. Le programme selon l'invention peut être en particulier téléchargé sur un réseau notamment de type Internet.

Alternativement, le support d'informations peut être un circuit intégré dans lequel le programme est incorporé, le circuit étant adapté pour exécuter ou pour être utilisé dans l'exécution du procédé en question.

Dans une autre implémentation, l'invention est mise en œuvre au moyen de composants logiciels et/ou matériels. Dans cette optique le terme module peut correspondre aussi bien à un composant logiciel ou à un composant matériel. Un composant logiciel correspond à un ou plusieurs programmes d'ordinateur, un ou plusieurs sous-programmes d'un programme, ou de manière plus générale à tout élément d'un programme ou d'un logiciel apte à mettre en œuvre une fonction ou un ensemble de fonction selon la description ci-dessus. Un composant matériel correspond à tout élément d'un ensemble matériel (ou hardware) apte à mettre en œuvre une fonction ou un ensemble de fonctions.

## Revendications

1. Equipement de télécommunication comportant un récepteur de signaux électromagnétiques (25_{f1}...25_{fn}) configuré pour recevoir des signaux de communication (sc), **caractérisé en ce que** l'équipement de télécommunication (2) comporte un détecteur (26) d'un signal électrique prédéfini (se) injecté dans un réseau de câbles (1) en fonction de signaux électromagnétiques (or) reçus par le récepteur (25_{f1}...25_{fn}).

2. Equipement de télécommunication selon la revendication précédente, **caractérisé en ce que** l'équipement de télécommunication (2) comporte :
• une interface de transmission filaire (23) apte à être connecté à un réseau de câbles (1), et
• un générateur (22) du signal électrique prédéfini (se) apte à être injecté dans le réseau de câbles (1) en utilisant l'interface de transmission filaire (23).

3. Equipement de télécommunication selon l'une quelconque des revendications précédentes, **caractérisé en ce que** l'équipement de télécommunication (2) comporte un contrôleur (21) d'émission de signaux électriques prédéfinis apte à déclencher (se_trg) une émission via une interface de transmission filaire (23, 33) d'un objet communicant (2, 3) du signal électrique prédéfini (se) dans un réseau de câble (1) auquel l'objet communicant (2, 3) est connecté au moyen de l'interface de transmission filaire (23, 33).

4. Equipement de télécommunication selon l'une quelconque des revendications précédentes, **caractérisé en ce que** le détecteur (26) de signal électrique prédéfini comporte un dispositif de mesure (261) du niveau du signal reçu (sr₁...srₙ) dans une bande de fréquence associé au récepteur (25_{f1}...25_{fn}).

5. Equipement de télécommunication selon l'une quelconque des revendications précédentes **caractérisé en ce que** l'équipement de télécommunication (2) comporte un générateur d'une information de localisation (264, 283) en fonction du signal électrique prédéfini détecté par le détecteur (26), l'information de localisation (il) étant apte à être reproduite par un dispositif de reproduction (29a, 29b).

6. Equipement de télécommunication selon la revendication précédente, **caractérisé en ce que** l'information de localisation (il) est apte à commander un indicateur du dispositif de reproduction (29a, 29b) en fonction du niveau de champ électromagnétique du signal électrique prédéfini (se) détecté par le détecteur (26).

7. Equipement de télécommunication selon l'une quelconque des revendications précédentes **caractérisé en ce que** l'équipement de télécommunication (2) comporte une caméra (27c) apte à capter une image unitaire (iu) lors de la mise en œuvre du détecteur (26) du signal électrique prédéfini, l'image unitaire (iu) étant apte à être fournie au générateur d'information de localisation (283).

8. Equipement de télécommunication selon la revendication précédente **caractérisé en ce que** l'équipement de télécommunication (2) comporte un générateur d'image étendue (282) en fonction d'images unitaires (iu) captées par la caméra (27c) lors de la mise en œuvre du détecteur (26) du signal électrique prédéfini, l'image étendue (ie) étant apte à représenter un collage des images unitaires (iu) et à être fournie au générateur d'information de localisation (283).

9. Equipement de télécommunication selon la revendication précédente **caractérisé en ce que** le générateur d'image étendue (282) utilise des données provenant d'au moins un accéléromètre (27a) de l'équipement de télécommunication (2).

10. Equipement de télécommunication selon l'une des revendications 7 à 9 **caractérisé en ce que** l'équipement de télécommunication (2) comporte un dispositif de traitement d'image (283) apte à surimposer sur une image (iu, ie) une information (il) en fonction du niveau de champ électromagnétique du signal électrique prédéfini (se) détecté par le détecteur, l'image traitée (ix) étant apte à être fournie au dispositif de reproduction (29a).

11. Objet communicant d'un réseau de communication comportant un équipement de télécommunication selon l'une des revendications 1 à 10, l'objet communicant comportant une interface de transmission filaire (33) configuré pour être connecté à un réseau de câbles (1), **caractérisé en ce que** l'objet communicant (3) comporte un générateur (32) d'un signal électrique prédéfini (se) apte à être injecté dans un réseau de câbles (1) en utilisant l'interface de transmission filaire (33).

12. Procédé de localisation de réseau de câbles apte à être mis en oeuvre par un équipement de télécommunication (2), le procédé de localisation (LOC) comportant une détection d'un signal électrique prédéfini (SE_DTCT) en fonction de signaux électromagnétiques reçus (or(se)) par un récepteur de signaux électromagnétique (25) de l'équipement de télécommunication (2) configuré pour recevoir des signaux de communication (sc) suite à une injection du signal électrique (se) dans un réseau de câbles (1).

13. Procédé de signalisation (SG) d'un réseau de câbles apte à être mis en oeuvre par un objet communicant (3) d'un réseau de communication comportant un équipement de télécommunication configuré pour mettre en oeuvre le procédé de localisation selon la revendication 12, le procédé de signalisation d'un réseau de câble comportant une génération d'un signal électrique prédéfini (SE_GN) apte à être injecté dans un réseau de câbles (1) en utilisant l'interface de transmission filaire de l'objet communicant (3).

14. Procédé de signalisation selon la revendication 13, **caractérisé en ce que** le signal électrique prédéfini (se) est émis sur une partie prédéterminée d'une bande de fréquence détectable par au moins un récepteur de signaux électromagnétiques (25) d'un équipement de télécommunication (2) apte à localiser un réseau de câbles (1).

15. Programme comprenant des instructions de code de programme pour l'exécution des étapes du procédé de localisation selon la revendication 12 et/ou du procédé de signalisation selon l'une quelconque des revendications 13 à 14 lorsque ledit programme est exécuté par un processeur d'un équipement de télécommunication.

## Patentansprüche

1. Telekommunikationseinrichtung, umfassend einen Empfänger elektromagnetischer Signale (25_{f1}...25_{fn}), der dazu ausgelegt ist, Kommunikationssignale (sc) zu empfangen, **dadurch gekennzeichnet, dass** die Telekommunikationseinrichtung (2) einen Detektor (26) für ein vorgegebenes elektrisches Signal (se) umfasst, das in ein Kabelnetz (1) in Abhängigkeit von elektromagnetischen Signalen (or) , die von dem Empfänger (25_{f1}...25_{fn}) empfangen werden, eingekoppelt wird.

2. Telekommunikationseinrichtung nach dem vorhergehenden Anspruch, **dadurch gekennzeichnet, dass** die Telekommunikationseinrichtung (2) umfasst:
• eine drahtgebundene Übertragungsschnittstelle (23), die geeignet ist, an ein Kabelnetz (1) angeschlossen zu werden, und
• einen Generator (22) für das vorgegebene elektrische Signal (se), das geeignet ist, unter Verwendung der drahtgebundenen Übertragungsschnittstelle (23) in das Kabelnetz (1) eingekoppelt zu werden.

3. Telekommunikationseinrichtung nach einem der vorhergehenden Ansprüche, **dadurch gekennzeichnet, dass** die Telekommunikationseinrichtung (2) eine Steuerung (21) zum Senden von vorgegebenen elektrischen Signalen umfasst, die geeignet ist, ein Senden, über eine drahtgebundene Übertragungsschnittstelle (23, 33) eines kommunizierenden Objekts (2, 3), des vorgegebenen elektrischen Signals (se) in ein Kabelnetz (1) auszulösen (se_trg), an welches das kommunizierende Objekt (2, 3) mittels der drahtgebundenen Übertragungsschnittstelle (23, 33) angeschlossen ist.

4. Telekommunikationseinrichtung nach einem der vorhergehenden Ansprüche, **dadurch gekennzeichnet, dass** der Detektor (26) für ein vorgegebenes elektrisches Signal eine Messvorrichtung (261) zum Messen des Pegels des empfangenen Signals (sr₁...srₙ) in einem dem Empfänger (25_{f1}...25_{fn}) zugeordneten Frequenzband umfasst.

5. Telekommunikationseinrichtung nach einem der vorhergehenden Ansprüche, **dadurch gekennzeichnet, dass** die Telekommunikationseinrichtung (2) einen Generator einer Ortungsinformation (264, 283) in Abhängigkeit von dem von dem Detektor (26) detektierten vorgegebenen elektrischen Signal umfasst, wobei die Ortungsinformation (il) geeignet ist, durch eine Wiedergabevorrichtung (29a, 29b) wiedergegeben zu werden.

6. Telekommunikationseinrichtung nach dem vorhergehenden Anspruch, **dadurch gekennzeichnet, dass** die Ortungsinformation (il) geeignet ist, einen Indikator der Wiedergabevorrichtung (29a, 29b) in Abhängigkeit von dem Pegel des elektromagnetischen Feldes des von dem Detektor (26) detektierten vorgegebenen elektrischen Signals (se) zu steuern.

7. Telekommunikationseinrichtung nach einem der vorhergehenden Ansprüche, **dadurch gekennzeichnet, dass** die Telekommunikationseinrichtung (2) eine Kamera (27c) umfasst, die geeignet ist, bei der Implementierung des Detektors (26) für das vorgegebene elektrische Signal ein Einzelbild (iu) zu erfassen, wobei das Einzelbild (iu) geeignet ist, an den Ortungsinformationsgenerator (283) übermittelt zu werden.

8. Telekommunikationseinrichtung nach dem vorhergehenden Anspruch, **dadurch gekennzeichnet, dass** die Telekommunikationseinrichtung (2) einen Generator eines erweiterten Bildes (282) in Abhängigkeit von von der Kamera (27c) bei der Implementierung des Detektors (26) für das vorgegebene elektrische Signal erfassten Einzelbildern (iu) umfasst, wobei das erweiterte Bild (ie) geeignet ist, eine Collage der Einzelbilder (iu) darzustellen und an den Ortungsinformationsgenerator (283) übermittelt zu werden.

9. Telekommunikationseinrichtung nach dem vorhergehenden Anspruch, **dadurch gekennzeichnet, dass** der Generator eines erweiterten Bildes (282) Daten verwendet, die von mindestens einem Beschleunigungsmesser (27a) der Telekommunikationseinrichtung (2) stammen.

10. Telekommunikationseinrichtung nach einem der Ansprüche 7 bis 9, **dadurch gekennzeichnet, dass** die Telekommunikationseinrichtung (2) eine Bildverarbeitungsvorrichtung (283) umfasst, die geeignet ist, in ein Bild (iu, ie) eine Information (il) in Abhängigkeit von dem Pegel des elektromagnetischen Feldes des von dem Detektor detektierten vorgegebenen elektrischen Signals (se) einzublenden, wobei das verarbeitete Bild (ix) geeignet ist, an die Wiedergabevorrichtung (29a) übermittelt zu werden.

11. Kommunizierendes Objekt eines Kommunikationsnetzes, das eine Telekommunikationseinrichtung nach einem der Ansprüche 1 bis 10 umfasst, wobei das kommunizierende Objekt eine drahtgebundene Übertragungsschnittstelle (33) umfasst, die dazu ausgelegt ist, an ein Kabelnetz (1) angeschlossen zu werden, **dadurch gekennzeichnet, dass** das kommunizierende Objekt (3) einen Generator (32) eines vorgegebenen elektrischen Signals (se) umfasst, das geeignet ist, unter Verwendung der drahtgebundenen Übertragungsschnittstelle (33) in ein Kabelnetz (1) eingekoppelt zu werden.

12. Verfahren zur Ortung eines Kabelnetzes, das geeignet ist, von einer Telekommunikationseinrichtung (2) implementiert zu werden, das Ortungsverfahren (LOC) umfassend eine Detektion eines vorgegebenen elektrischen Signals (SE_DTCT) in Abhängigkeit von elektromagnetischen Signalen (or(se)), die von einem Empfänger elektromagnetischer Signale (25) der Telekommunikationseinrichtung (2) empfangen werden, der dazu ausgelegt ist, Kommunikationssignale (sc) nach einer Einkopplung des elektrischen Signals (SE) in ein Kabelnetz (1) zu empfangen.

13. Verfahren zur Signalisierung (SG) eines Kabelnetzes, das geeignet ist, von einem kommunizierenden Objekt (3) eines Kommunikationsnetzes implementiert zu werden, das eine Telekommunikationseinrichtung umfasst, die dazu ausgelegt ist, das Verfahren zur Ortung nach Anspruch 12 zu implementieren, wobei das Verfahren zur Signalisierung eines Kabelnetzes das Erzeugen eines vorgegebenen elektrischen Signals (SE_GN) umfasst, das geeignet ist, unter Verwendung der drahtgebundenen Übertragungsschnittstelle des kommunizierenden Objekt (3) in ein Kabelnetz (1) eingekoppelt zu werden.

14. Verfahren zur Signalisierung nach Anspruch 13, **dadurch gekennzeichnet, dass** das vorgegebene elektrische Signal (se) über einen vorbestimmten Teil eines Frequenzbandes gesendet wird, das von mindestens einem Empfänger elektromagnetischer Signale (25) einer Telekommunikationseinrichtung (2) detektierbar ist, die in der Lage ist, ein Kabelnetz (1) zu orten.

15. Programm, das Programmcodeanweisungen umfasst, die bei der Ausführung des Programms durch einen Prozessor einer Telekommunikationseinrichtung die Schritte des Verfahrens zur Ortung nach Anspruch 12 und/oder des Verfahrens zur Signalisierung nach einem der Ansprüche 13 bis 14 ausführen.

## Claims

1. Telecommunication equipment comprising a receiver (25_{f1}...25_{fn}) of electromagnetic signals which is configured to receive communication signals (sc), **characterized in that** the telecommunication equipment (2) comprises a detector (26) of a predefined electrical signal (se) injected into a cable network (1) depending on electromagnetic signals (or) received by the receiver (25_{f1}...25_{fn}).

2. Telecommunication equipment according to the preceding claim, **characterized in that** the telecommunication equipment (2) comprises:
• a wired transmission interface (23) which is able to be connected to a cable network (1), and
• a generator (22) of the predefined electrical signal (se) which is able to be injected into the cable network (1) using the wired transmission interface (23).

3. Telecommunication equipment according to any one of the preceding claims, **characterized in that** the telecommunication equipment (2) comprises a controller (21) of transmission of predefined electrical signals which is able to trigger (se_trg) transmission, via a wired transmission interface (23, 33) of a communicating object (2, 3), of the predefined electrical signal (se) in a cable network (1) to which the communicating object (2, 3) is connected by means of the wired transmission interface (23, 33).

4. Telecommunication equipment according to any one of the preceding claims, **characterized in that** the predefined electrical signal detector (26) comprises a device (261) for measuring the level of the received signal (sr₁...srₙ) in a frequency band associated with the receiver (25_{f1}...25_{fn}).

5. Telecommunication equipment according to any one of the preceding claims, **characterized in that** the telecommunication equipment (2) comprises a generator (264, 283) of location information depending on the predefined electrical signal detected by the detector (26), the location information (il) being able to be reproduced by a reproduction device (29a, 29b).

6. Telecommunication equipment according to the preceding claim, **characterized in that** the location information (il) is able to control an indicator of the reproduction device (29a, 29b) depending on the electromagnetic field level of the predefined electrical signal (se) detected by the detector (26).

7. Telecommunication equipment according to any one of the preceding claims, **characterized in that** the telecommunication equipment (2) comprises a camera (27c) which is able to capture a unitary image (iu) when the detector (26) of the predefined electrical signal is implemented, the unitary image (iu) being able to be supplied to the location information generator (283).

8. Telecommunication equipment according to the preceding claim, **characterized in that** the telecommunication equipment (2) comprises an extended image generator (282) depending on unitary images (iu) captured by the camera (27c) when the detector (26) of the predefined electrical signal is implemented, the extended image (ie) being able to represent a collage of the unitary images (iu) and to be supplied to the location information generator (283).

9. Telecommunication equipment according to the preceding claim, **characterized in that** the extended image generator (282) uses data originating from at least one accelerometer (27a) of the telecommunication equipment (2).

10. Telecommunication equipment according to one of Claims 7 to 9, **characterized in that** the telecommunication equipment (2) comprises an image processing device (283) which is able to superimpose on an image (iu, ie) information (il) depending on the electromagnetic field level of the predefined electrical signal (se) detected by the detector, the processed image (ix) being able to be supplied to the reproduction device (29a).

11. Communicating object of a communication network comprising telecommunication equipment according to one of Claims 1 to 10, the communicating object comprising a wired transmission interface (33) configured to be connected to a cable network (1), **characterized in that** the communicating object (3) comprises a generator (32) of a predefined electrical signal (se) which is able to be injected into a cable network (1) using the wired transmission interface (33).

12. Method for locating a cable network which is able to be implemented by telecommunication equipment (2), the location method (LOC) comprising detecting a predefined electrical signal (SE_DTCT) depending on electromagnetic signals (or(se)) received by an electromagnetic receiver (25) of signals of the telecommunication equipment (2) which is configured to receive communication signals (sc) after the electrical signal (se) is injected into a cable network (1).

13. Signalling method (SG) of a cable network which is able to be implemented by a communicating object (3) of a communication network comprising telecommunication equipment configured to implement the location method according to Claim 12, the signalling method of a cable network comprising generating a predefined electrical signal (SE_GN) which is able to be injected into a cable network (1) using the wired transmission interface of the communicating object (3).

14. Signalling method according to Claim 13, **characterized in that** the predefined electrical signal (se) is transmitted over a predetermined part of a frequency band which can be detected by at least one receiver (25) of electromagnetic signals of telecommunication equipment (2) which is able to locate a cable network (1).

15. Program comprising program code instructions for executing the steps of the location method according to Claim 12 and/or of the signalling method according to either one of Claims 13 and 14 when said program is executed by a processor of telecommunication equipment.
